**Europäisches Patentamt**

**European Patent Office**

**Office européen des brevets**

(19)

(11) Veröffentlichungsnummer : **0 172 402 B1**

(12) # EUROPÄISCHE PATENTSCHRIFT

(45) Veröffentlichungstag der Patentschrift :
15.03.89

(21) Anmeldenummer : 85108823.7

(22) Anmeldetag : 15.07.85

(51) Int. Cl.⁴ : **G 01 R 33/02**, G 01 D 3/02

(54) **Schaltungsanordnung zur Kompensation von Schwankungen des Uebertragungsfaktors eines Magnetfeldsensors.**

(30) Priorität : 16.08.84 CH 3935/84

(43) Veröffentlichungstag der Anmeldung :
26.02.86 Patentblatt 86/09

(45) Bekanntmachung des Hinweises auf die Patenterteilung : 15.03.89 Patentblatt 89/11

(84) Benannte Vertragsstaaten :
AT BE DE FR GB IT NL SE

(56) Entgegenhaltungen :
EP--A-- 0 018 750
DE--B-- 1 297 755
GB--A-- 1 124 576
JOURNAL OF APPLIED PHYSICS, Band 53, Nr. 11,
November 1982, Seiten 8257-8259, American Institute
of Physics, New York, US; P. DANIIL et al.: "Low field
Hall effect magnetometry"

(73) Patentinhaber : **LGZ LANDIS & GYR ZUG AG**

**CH-6301 Zug (CH)**

(72) Erfinder : **Petr, Jan**
**Stolzengrabenstrasse 33**
**CH-6317 Oberwil (CH)**
Erfinder : **Lienhard, Heinz**
**Rosenbergweg 14**
**CH-6300 Zug (CH)**

(74) Vertreter : **Müller, Hans-Jürgen, Dipl.-Ing. et al**
**Müller, Schupfner & Gauger Lucile-Grahn-Strasse 38**
**Postfach 80 13 69**
**D-8000 München 80 (DE)**

**Beschreibung**

Die Erfindung bezieht sich auf Schaltungsanordnungen zur Kompensation von Schwankungen des Uebertragungsfaktors eines Magnetfeldsensors der im Oberbegriff der Ansprüche 1 und 4 genannten Art.

Es ist bekannt, einen elektrischen Strom über das von ihm erzeugte Magnetfeld potentialfrei zu messen. Zur Ermittlung der Stärke des Magnetfeldes dienen Magnetfeldsensoren, z. B. Hallgeneratoren, Magnetotransistoren und andere Halbleiterelemente, die ein zum Magnetfeld mehr oder weniger proportionales Ausgangssignal erzeugen. Um den Einfluss von Nichtlinearitäten und Schwankungen der Steigung der Uebertragungskennlinie des Magnetfeldsensors auf das Messresultat zu unterdrücken, kann mittels eines Regelkreises und einer Magnetspule ein magnetisches Gegenfeld erzeugt werden, welches das zu messende Magnetfeld praktisch vollständig kompensiert (DE-B-26 21 302). Nachteilig bei solchen sogenannten kompensierten Wandlern ist der verhältnismässig hohe Leistungsaufwand zur Erzeugung des kompensierenden Magnetfeldes.

Im Dokument EP-A-0 137 896 ist eine Schaltungsanordnung beschrieben, in der einem zu messenden Magnetfeld mittels einer Magnetspule ein Hilfsmagnetfeld bekannter Grösse überlagert wird, in der die Steigung der Uebertragungskennlinie des Magnetfeldsensors bestimmt wird durch die Ermittlung des allein durch das Hilfsmagnetfeld erzeugten Anteils des Ausgangssignals des Magnetfeldsensors und in der anschliessend die Ausgangsspannung des Magnetfeldsensors durch die so ermittelte Steigung dividiert wird.

Eine Schaltungsanordnung der eingangs genannten Art ist aus der GB-A-1 124 576 bekannt, in der ein Regelkreis einen synchronen Detektor enthält, der als Mittel zur Bestimmung eines allein durch ein Hilfsmagnetfeld erzeugten Anteils der Ausgangsspannung eines Hallelementes verwendet wird in Kombination mit einer Referenzspannung und der Ausgangsspannung eines Signalgenerators. Diese Schaltungsanordnung hat die Eigenschaft, dass eine zeitliche und/oder temperaturmässige Abwanderung einer dieser beiden Spannungen, d. h. deren Unstabilität, sich voll auf die Regelgenauigkeit des Regelkreises und damit auf die Kompensationsgenauigkeit der Schaltungsanordnung auswirkt. Ausserdem werden die Eingänge des synchronen Detektors von zwei Spannungen gespeist, die um Grössenordnungen auseinanderliegen, so dass es schwierig ist die Dynamik des synchronen Detektors optimal auszunutzen.

Der Erfindung liegt die Aufgabe zugrunde, die aus der GB-A-1 124 576 bekannte Schaltungsanordnung aufwandsökonomisch derart zu verbessern, dass die in irgend einer Form immer vorhandenen Unstabilitäten der verwendeten Referenzspannung und Generatorausgangsspannung die Kompensationsgenauigkeit der Schaltungsanordnung mindestens nicht mehr, wenn überhaupt, so stark beeinflussen können und/oder dass die Dynamik des verwendeten Mittels zur Bestimmung des allein durch das Hilfsmagnetfeld erzeugten Anteils der Ausgangsspannung des Magnetfeldsensors optimal ausgenutzt werden kann.

Die genannte Aufgabe wird bei Schaltungsanordnungen der eingangs genannten Art erfindungsgemäss durch die im Kennzeichen der Ansprüche 1 und 4 angegebenen Merkmale gelöst.

Ausführungsbeispiele der Erfindung sind in der Zeichnung dargestellt und werden im folgenden näher beschrieben.

Es zeigen :

Fig. 1 ein Blockschaltbild einer vereinfachten ersten Variante einer Schaltungsanordnung zur Kompensation der Schwankungen des Uebertragungsfaktors eines Magnetfeldsensors,

Fig. 2 ein Blockschaltbild einer verbesserten zweiten Variante einer solchen Schaltungsanordnung,

Fig. 3 ein Blockschaltbild einer erweiterten dritten Variante einer solchen Schaltungsanordnung,

Fig. 4 ein Blockschaltbild einer verbesserten vierten Variante einer solchen Schaltungsanordnung,

Fig. 5 eine Skizze einer räumlichen Anordnung von zwei Magnetfeldsensoren und einer Flachspule,

Fig. 6 ein Blockschaltbild einer ersten Variante einer Korrelator/Regler-Schaltung,

Fig. 7 ein Blockschaltbild einer zweiten Variante einer Korrelator/Regler-Schaltung und

Fig. 8 ein Schaltbild eines Integrators.

Gleiche Bezugszeichen bezeichnen in allen Figuren der Zeichnung gleiche Teile.

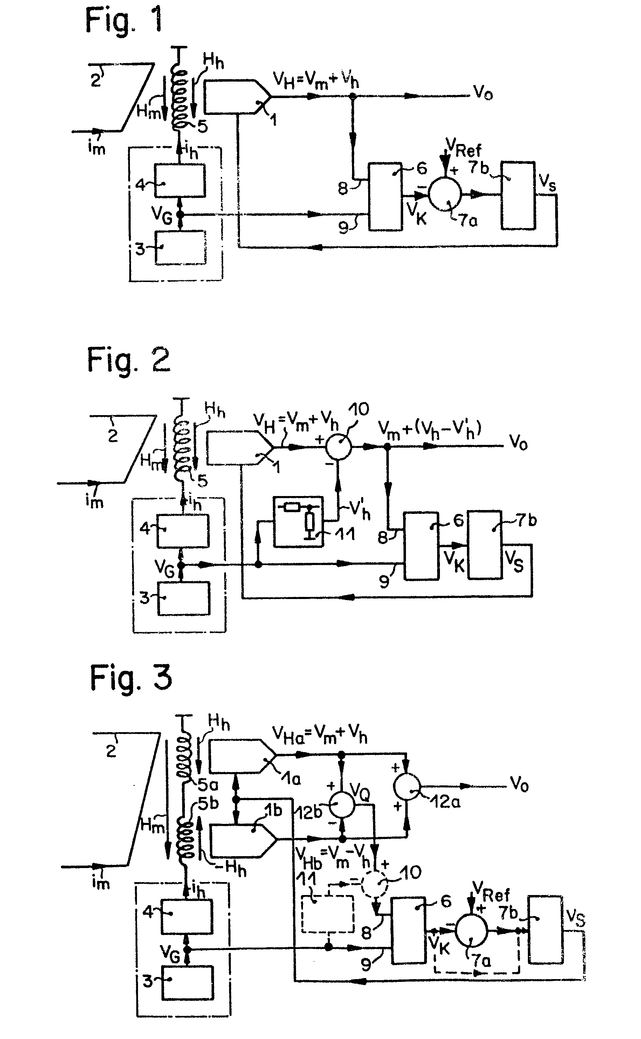

In der Fig. 1 bedeutet 1 einen Magnetfeldsensor. Der Magnetfeldsensor 1 kann zur Messung eines in einem elektrischen Leiter 2 fliessenden Messstromes $i_m$ über das von ihm erzeugte Magnetfeld $H_m$ dienen. Die Einkopplung des vom Messstrom $i_m$ erzeugten Magnetfeldes $H_m$ in den Magnetfeldsensor 1 kann in bekannter Weise mittels eines Magnetkernes oder auch ohne einen Magnetkern dadurch erfolgen, dass der Magnetfeldsensor 1 auf der Oberfläche des als Flachleiter ausgebildeten Leiters 2 angeordnet wird. Der Magnetfeldsensor 1 gibt an seinem Ausgang eine vom Magnetfeld $H_m$ abhängige Spannung $V_H$ ab und arbeitet somit als Magnetfeld/Spannungs-Wandler. Dieser Magnetfeldsensor 1 kann z. B. ein Hallelement sein. Die Steigung der Uebertragungskennlinie des Magnetfeldsensors 1 ist eine Funktion der Temperatur und zudem auch alterungsbedingten Schwankungen unterworfen, so dass ohne besondere Massnahmen eine genaue Messung des Magnetfeldes $H_m$ nicht möglich ist.

Ausser dem Magnetfeldsensor 1 enthält die in der Fig. 1 dargestellte Schaltungsanordnung noch einen Spannungsgenerator 3, einen Spannungs/Strom-Wandler 4, eine Spule 5, einen Korrelator 6, einen ersten Differenzgeber 7a und einen Regler 7b. Der Regler 7b ist z. B. ein Integralregler. Der Ausgang des

2

EP 0 172 402 B1

Spannungsgenerators 3 ist mit dem Eingang des Spannungs/Strom-Wandlers 4 verbunden, während dessen Ausgang auf einen Pol der Spule 5 geführt ist, deren anderer Pol an Masse liegt. Der Spannungsgenerator 3 und der Spannungs/Strom-Wandler 4 bilden zusammen einen Stromgenerator 3 ; 4, an dessen Stromausgang, der gleichzeitig der Ausgang des Spannungs/Strom-Wandlers 4 ist, die Spule 5 angeschlossen ist zur Erzeugung eines dem zu messenden Magnetfeld $H_m$ überlagerten Hilfsmagnetfeldes $H_h$. Der Stromgenerator 3 ; 4 besitzt ausserdem noch einen Spannungsausgang, der gleichzeitig der Ausgang des Spannungsgenerators 3 ist. Der Leiter 2 und die Spule 5 sind raümlich so angeordnet, dass die mit ihrer Hilfe erzeugten Magnetfelder $H_m$ und $H_h$ wenigstens annähernd die gleiche Richtung besitzen. Der Korrelator 6 besitzt zwei Eingänge, von denen der erste Eingang 8 am Ausgang des Magnetfeldsensors 1 und der zweite Eingang 9 am Spannungsausgang des Stromgenerators 3 ; 4 angeschlossen ist. Der Ausgang des Korrelators 6 ist mit einem ersten, z. B. mit dem Minus-Eingang des ersten Differenzgebers 7a verbunden, dessen Ausgang seinerseits auf den Eingang des Reglers 7b geführt ist. Der zweite, z. B. Plus-Eingang des ersten Differenzgebers 7a liegt an einer konstanten Referenzspannung $V_{Ref}$. Der Ausgang des Reglers 7b ist auf einen Steuereingang des Magnetfeldsensors 1 geführt, der den Uebertragungskoeffizient des Magnetfeldsensors 1 beeinflusst. Der Ausgang des Magnetfeldsensors 1 ist gleichzeitig der Ausgang der in der Fig. 1 dargestellten Schaltungsanordnung.

Die beschriebene Schaltungsanordnung arbeitet wie folgt : Die Ausgangsspannung $V_G$ des Spannungsgenerators 3 erzeugt mit Hilfe des vom Spannungs/Strom-Wandler 4 gelieferten proportionalen Hilfsstromes $i_h$ und der von diesem Hilfsstrom $i_h$ durchflossenen Spule 5 das Hilfsmagnetfeld $H_m$. Das Hilfsmagnetfeld $H_m$ hat einen bekannten zeitlichen Verlauf und eine bekannte Grösse. Die Amplitude des Hilfsmagnetfeldes $H_h$ ist in der Praxis nur einige Prozent des Maximalwertes der Amplitude des zu messenden Magnetfeldes $H_m$, so dass kein grosser Leistungsaufwand zur Erzeugung des Hilfsmagnetfeldes $H_m$ erforderlich ist. Der Magnetfeldsensor 1 wandelt die beiden Magnetfelder $H_m$ und $H_h$ um in Ausgangsspannungen $V_m$ und $V_h$, so dass die Ausgangsspannung $V_H$ des Magnetfeldsensors 1 gleich der Summe $(V_m + V_h)$ ist, die als Eingangsspannung den ersten Eingang 8 des Korrelators 6 speist. Der Korrelator 6 korreliert die Spannung $V_H = V_m + V_h$ mit der Ausgangsspannung $V_G$ des Spannungsgenerators 3, die ursächlich das Hilfsmagnetfeld $H_h$ und damit auch die Spannung $V_h$ erzeugt. Mit anderen Worten, der Korrelator 6 ist ein Mittel zur Bestimmung des allein durch das Hilfsmagnetfeld $H_h$ erzeugten Anteils $V_h$ der Ausgangsspannung $V_H$ des Magnetfeldsensors 1. Diesem Anteil $V_h$ entspricht am Ausgang des Korrelators 6 eine Gleichspannung $V_K$, die nach ihrem Vergleich mit der als Sollwert wirksamen Referenzspannung $V_{Ref}$ über den Regler 7 als Regelspannung $V_S$ auf den Steuereingang des Magnetfeldsensors 1 wirksam ist. Die Regelschleife 1 ; 6 ; 7a ; 7b sorgt dafür, dass die Spannung $V_K$ und somit auch der Uebertragungsfaktor des Magnetfeldsensors 1 für $H_h$ konstant bleibt. Da der Magnetfeldsensor 1 für die beiden Magnetfelder $H_m$ und $H_h$ einen annähernd gleichen Uebertragungsfaktor besitzt, bedeutet dies, dass auch der Uebertragungsfaktor für das zu messende Magnetfeld $H_m$ temperatur- und alterungskompensiert wird.

Die in der Fig. 2 dargestellte Schaltungsanordnung entspricht annähernd der Schaltungsanordnung nach der Fig. 1, nur dass in ihr der Ausgang des Magnetfeldsensors 1 nicht direkt, sondern über einen zweiten Differenzgeber 10 mit dem ersten Eingang 8 des Korrelators 6 verbunden ist, wobei der Ausgang des Magnetfeldsensors 1 auf einen ersten, z. B. den Plus-Eingang des zweiten Differenzgebers 10 und dessen Ausgang auf den ersten Eingang 8 des Korrelators 6 geführt ist, und dass der zweite, z. B. Minus-Eingang des zweiten Differenzgebers 10 über ein Dämpfungsglied 11 mit dem zweiten Eingang 9 des Korrelators 6 und damit auch mit dem Spannungsausgang des Stromgenerators 3 ; 4 verbunden ist. Der Ausgang des zweiten Differenzgebers 10 ist gleichzeitig der Ausgang der in der Fig. 2 dargestellten Schaltungsanordnung.

Die beschriebene Schaltungsanordnung arbeitet ähnlich wie die in der Fig. 1 dargestellte Schaltungsanordnung, nur dass in ihr mit Hilfe des zweiten Differenzgebers 10 von der Ausgangsspannung $V_H = V_m + V_h$ des Magnetfeldsensors 1 die Ausgangsspannung $V_h' = k \cdot V_G$ des Dämpfungsgliedes 11 subtrahiert wird, bevor sie dem Korrelator 6 und dem Ausgang der Schaltungsanordnung zugeführt wird, wobei k der Uebertragungsfaktor des Dämpfungsgliedes 11 ist. Es gilt somit

$$V_0 = (V_m + V_h) - V_h' = V_m + \Delta V_h \text{ mit}$$
$$\Delta V_h = V_h - V_h' = V_h - kV_G .$$

Für die Ausgangsspannung $V_G$ des Spannungsgenerators 3 gibt es zwei verschiedene Uebertragungswege : Sie erreicht den Ausgang des Differenzgebers 10 einerseits als Spannung $V_h$ über den Spannungs/Strom-Wandler 4, die Spule 5 und den Magnetfeldsensor 1 und anderseits als Spannung $V_h'$ über das Dämpfungsglied 11. Sind die Uebertragungsfaktoren dieser beiden Wege gleich oder, anders formuliert, wird die Dämpfung des Dämpfungsgliedes 11 so gewählt, dass sein Uebertragungsfaktor gleich demjenigen des anderen Weges ist, dann gilt $\Delta V_h = 0$ und $V_0 = V_m$. Die Ausgangsspannung der in der Fig. 2 dargestellten Schaltungsanordnung enthält somit nicht mehr die durch das Hilfsmagnetfeld $H_h$ erzeugte Spannung $V_h$. Temperatur- oder alterungsbedingte Schwankungen des Uebertragungsfaktors des Magnetfeldsensors 1 stören die Gleichheit der Uebertragungsfaktoren der beiden Wege, so dass ein kleiner Wert $\Delta V_h \neq 0$ am Ausgang des Differenzgebers 10 erscheint. Der Korrelator 6 bestimmt den $V_h$

3

proportionalen Anteil der Ausgangsspannung $V_H$ des Magnetfeldsensors 1. Die vom Regler 7b erzeugte Regelspannung $V_S$ verstellt wiederum den Wert des Uebertragungskoeffizienten des Magnetfeldsensors 1 so, dass die Spannung $\Delta V_h$ wieder gleich Null wird und somit die Wirkung der temperatur- oder alterungsbedingten Aenderung des Uebertragungsfaktors des Magnetfeldsensors 1 wieder rückgängig gemach wird. Das Dämpfungsglied 11 ist z. B. ein aus zwei Widerständen bestehender Spannungsteiler. Die Schaltungsanordnung nach Fig. 2 hat somit den Vorteil, dass ihre Ausgangsspannung nicht mehr die vom Hilfsmagnetfeld $H_h$ erzeugte Spannung $V_h$, sondern nur mehr die praktisch vernachlässigbare Differenzspannung $\Delta V_h$ enthält. Es gibt demnach keine Hilfsspannung $V_h$ am Ausgang der in der Fig. 2 dargestellten Schaltung, die die Weiterverarbeitung des Nutzsignales eventuell stören könnte. Ausserdem muss der Uebertragungsfaktor des Korrelators 6 nicht mehr sehr stabil sein, da er nur die Regeldifferenz detektiert. Auch die Ausgangsspannung $V_G$ des Spannungsgenerators 3 muss nicht stabil sein.

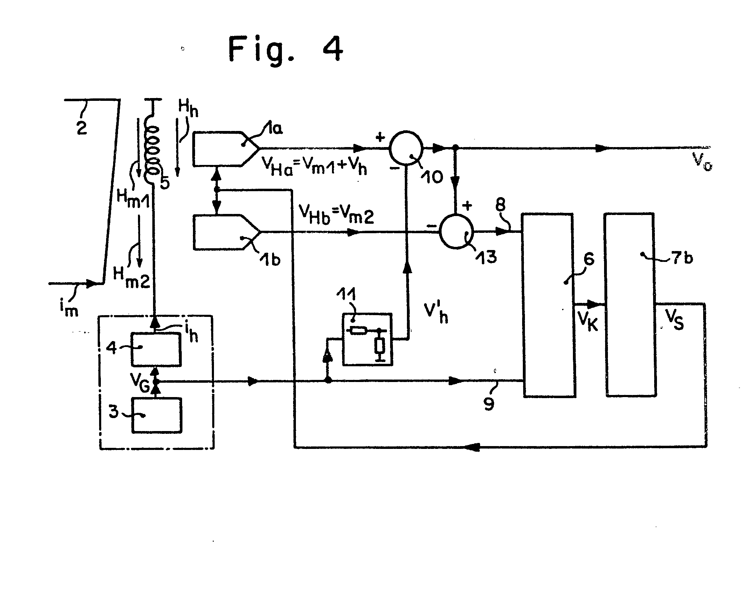

Die in den Figuren 1 und 2 dargestellten Schaltungsanordnungen stellen durch das Vorhandensein der relativ hohen Spannung $V_m$ am ersten Eingang 8 des Korrelators 6 relativ hohe Anforderungen an dessen Dynamik. Um diese Anforderungen stark zu reduzieren, ist es von Vorteil, eine der beiden in der Fig. 3 bzw. in der Fig. 4 dargestellten Schaltungsanordnungen zu verwenden. In der in der Fig. 3 dargestellten Schaltungsanordnung besteht die Spule 5 aus zwei annähernd gleichen Teilspulen 5a und 5b. Jeder Teilspule 5a und 5b ist ein annähernd gleicher Magnetfeldsensor 1a bzw. 1b zugeordnet, dessen Ausgang jeweils über eine gemeinsame Additionsschaltung 12a, die zwei Eingänge besitzt, mit dem Ausgang der Schaltungsanordnung verbunden ist. Die beiden Teilspulen 5a und 5b, die z. B. elektrisch in Reihe geschaltet sind, werden vom gemeinsamen Stromgenerator 3 ; 4 mit dem gleichen Hilfsstrom $i_h$ gespeist und erzeugen je ein Hilfsmagnetfeld $H_h$ bzw. $-H_h$, die beide einen gleichen Absolutwert, aber entgegengesetzte Richtung besitzen. Die Ausgänge der beiden Magnetfeldsensoren 1a und 1b sind zusätzlich in einer ersten Variante über einen gemeinsamen dritten Differenzgeber 12b direkt mit dem ersten Eingang 8 des Korrelators 6 verbunden. Der Korrelator 6 ist wieder ein Mittel zur Bestimmung des allein, diesmal durch die beiden Hilfsmagnetfelder $H_h$ und $-H_h$ erzeugten Anteils der Ausgangsspannungen $V_{Ha}$ und $V_{Hb}$ der beiden Magnetfeldsensoren 1a und 1b. Deren beide Steuereingänge sind miteinander und mit dem Ausgang des Reglers 7b verbunden. Der Ausgang des Korrelators 6 ist in dieser ersten Variante mit dem Minus-Eingang des ersten Differenzgebers 7a verbunden, während dessen Ausgang auf den Eingang des Reglers 7b geführt ist. Der Plus-Eingang des ersten Differenzgebers 7a liegt an die Referenzspannung $V_{Ref}$.

In einer zweiten Variante, die in der Fig. 3 gestrichelt dargestellt ist, ist der Ausgang des Korrelators 6 direkt auf den Eingang des Reglers 7b geführt, d. h. der erste Differenzgeber 7a ist nicht mehr vorhanden. Statt dessen sind der zweite Differenzgeber 10 und das Dämpfungsglied 11 vorhanden, wobei der Ausgang des dritten Differenzgebers 12b mit dem Plus-Eingang und der Ausgang des Dämpfungsgliedes 11 mit dem Minus-Eingang des zweiten Differenzgebers 10 verbunden ist, dessen Ausgang seinerseits auf den ersten Eingang 8 des Korrelators 6 geführt ist. Der Eingang des Dämpfungsgliedes 11 ist wieder mit dem Spannungsausgang des Stromgenerators 3 ; 4 verbunden.

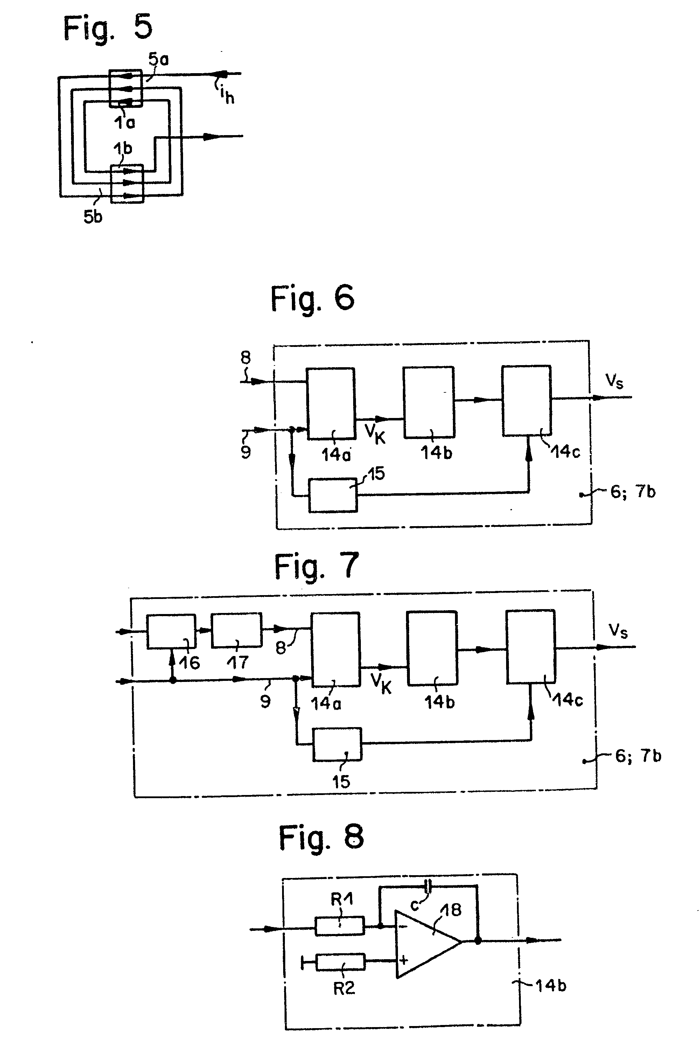

Die beiden Teilspulen 5a und 5b sind z. B. je ein Teil einer gemeinsamen Spule 5. Sie bestehen z. B. jeweils nur aus, wie in der Fig. 5 dargestellt, parallelen und von dem durch den Stromgenerator 3 ; 4 gelieferten Hilfsstrom $i_h$ in gleicher Richtung durchflossenen Leitern, wobei die Stromrichtung in den beiden Teilspulen 5a und 5b parallele und entgegengesetzte Richtungen besitzen. In der Darstellung der Fig. 5 ist die Stromrichtung in der Teilspule 5a von rechts nach links und in der Teilspule 5b von links nach rechts.

Die Spule 5 bzw. die Teilspulen 5a und 5b der in den Figuren 1 bis 5 dargestellten Schaltungsanordnungen sind z. B. Flachspulen, die an der Oberfläche auf einem Halbleiterkristall angeordnet sind, in dem mindestens der Magnetfeldsensor 1 bzw. die beiden Magnetfeldsensoren 1a und 1b integriert sind. Die Flachspule ist z. B. spiralförmig und besitzt annähernd rechteckförmige Windungen. Eine solche vom Hilfsstrom $i_h$ durchflossene Flachspule ist in der Fig. 5 dargestellt. Wird die in der Fig. 5 dargestellte Flachspule in Zusammenhang mit der in der Fig. 3 dargestellten Schaltungsanordnung verwendet, dann stellen zwei diametral gegenüberliegende Teile der Flachspule jeweils eine Teilspule 5a bzw. 5b dar, wobei jeweils unter der Teilspule 5a bzw. 5b der zugehörige Magnetfeldsensor 1a bzw. 1b angeordnet ist. Wie aus der Fig. 5 leicht ersichtlich ist, sind die Leiter einer jeden Teilspule 5a bzw. 5b alle parallel und werden innerhalb einer Teilspule vom Hilfsstrom $i_h$ in der gleichen Richtung durchflossen. Der Hilfsstrom $i_h$ besitzt dabei z. B. einen Wert $\leq$ 1 mA.

Unter der Annahme, dass die Uebertragungsfaktoren der Teilspulen 5a und 5b einerseits und diejenigen der Magnetfeldsensoren 1a und 1b anderseits gleich gross sind, gelten für die in der Fig. 3 dargestellte Schaltungsanordnung folgende Gleichungen :

$$V_{Ha} = V_m + V_h \,,$$
$$V_{Hb} = V_m - V_h \,,$$
$$V_0 = V_{Ha} + V_{Hb} = (V_m + V_h) + (V_m - V_h) = 2\,V_m \text{ und}$$
$$V_Q = V_{Ha} - V_{Hb} = (V_m + V_h) - (V_m - V_h) = 2\,V_h \,,$$

wobei $V_{Ha}$ und $V_{Hb}$ die Ausgangsspannung der Magnetfeldsensoren 1a und 1b, $V_m$ der vom zu messenden Magnetfeld $H_m$ erzeugte und $V_h$ sowie $-V_h$ die von den Hilfsmagnetfeldern $H_h$ bzw. $-H_h$

jeweils am Ausgang eines Magnetfeldsensors 1a bzw. 1b erzeugten Spannungsanteile und $V_Q$ die Ausgangsspannung des dritten Differenzgebers 12b sind. Für den oben erwähnten Idealfall einer gleich grossen Uebertragung der Magnetfeldsensoren 1a und 1b enthält die Ausgangsspannung $V_o$ der in der Fig. 3 dargestellten Schaltungsanordnung somit genau wie die in der Fig. 2 dargestellte Schaltung keinen durch ein Hilfsmagnetfeld $H_h$ bzw. — $H_h$ erzeugten Spannungsanteil $V_h$ bzw. — $V_h$. Zusätzlich enthält bei beiden Varianten die Eingangsspannung am ersten Eingang 8 des Korrelators 6 keinen Spannungsanteil $V_m$, so dass keine grossen Anforderungen mehr an die Dynamik des Korrelators 6 gestellt werden müssen. Die in der Fig. 4 dargestellte Schaltungsanordnung ist ähnlich aufgebaut wie die in der Fig. 2 dargestellte Schaltungsanordnung, nur dass der Ausgang des zweiten Differenzgebers 10, der gleich wie in der Fig. 2 der Ausgang der Schaltungsanordnung ist, diesmal nicht direkt, sondern über einen vierten Differenzgeber 13 mit dem ersten Eingang 8 des Korrelators 6 verbunden ist. Zusätzlich zu einem ersten Magnetfeldsensor 1a, dem die Spule 5 zugeordnet ist, ist noch ein zweiter Magnetfeldsensor 1b vorhanden, der allein zur Ermittlung des zu messenden Magnetfeldes $H_m$ dient und dem keine Spule zugeordnet ist. Der Ausgang des ersten Magnetfeldsensors 1a ist mit dem Plus-Eingang und der mit dem Ausgang des Stromgenerators 3 ; 4 verbundene Eingang 9 des Korrelators 6 über das Dämpfungsglied 11 mit dem Minus-Eingang des zweiten Differenzgebers 10 verbunden, während dessen Ausgang mit dem Plus-Eingang und der Ausgang des zweiten Magnetfeldsensors 1b mit dem Minus-Eingang des vierten Differenzgebers 13 verbunden ist, dessen Ausgang seinerseits am anderen ersten Eingang 8 des Korrelators 6 angeschlossen ist.

Es gelten für die in der Fig. 4 dargestellte Schaltungsanordnung folgende Gleichungen :

$$V_{Ha} = V_{m1} + V_h \, ,$$
$$V_{Hb} = V_{m2} ,$$
$$V_0 = V_{Ha} - V_h' = V_{m1} + (V_h - V_h') \, ,$$
$$V_8 = (V_{Ha} - V_h') - V_{Hb} = (V_{m1} + V_h - V_h') - V_{m2} =$$
$$= (V_{m1} - V_{m2}) + (V_h - V_h') \, ,$$

wobei $V_8$ die Spannung am ersten Eingang 8 des Korrelators 6 ist.

Durch die Wirkung der Regelschleife wird wie in der Anordnung nach Fig. 2 und nach Fig. 3 die Differenzspannung

$$\Delta V_h = V_h - V_h' = 0$$

und somit

$$V_0 = V_{m1} \text{ und}$$
$$V_8 = V_{m1} - V_{m2}$$

Diese Gleichungen zeigen, dass im Gegensatz zur Anordnung der Fig. 3 auch mit einer beliebig grossen Unsymmetrie der beiden Magnetfeldsensoren 1a und 1b, d. h. mit beliebig unterschiedlichem $V_{m1}$ und $V_{m2}$, die Ausgangsspannung $V_o$ keine störende Hilfsspannung $\Delta V_h$ enthält.

Die Symmetrie der Magnetfeldsensoren 1a und 1b ist nur für die erreichbare Verbesserung der Dynamik des Korrelators 6 massgebend.

Die Signalform der Ausgangsspannung $V_G$ des Stromgenerators 3 ; 4 ist im Prinzip beliebig. Mit einer rechteckförmigen Ausgangsspannung $V_G$ ist der Korrelator 6 besonders einfach zu realisieren. Die Kaskadenschaltung 6 ; 7b des Korrelators 6 und des Reglers 7b kann in diesem Fall in den Schaltungen der Fig. 2, der Fig. 4 und der zweiten Variante der Fig. 3 durch eine der beiden in den Figuren 6 und 7 dargestellten Korrelator/Regler-Schaltungen ersetzt werden. In den Figuren 6 und 7 ist ein Multiplikationsglied 14a mit einem nachgeschalteten Integrator 14b in Kaskade geschaltet und der Ausgang des Integrators 14b über eine Abtast/Halte-Schaltung 14c (« Sample and hold circuit ») mit dem Steuereingang des bzw. der Magnetfeldsensoren 1 bzw. 1a und 1b verbunden. Die beiden bisherigen Eingänge 8 und 9 des Korrelators 6 entsprechen in den Figuren 6 und 7 den Eingängen 8 und 9 der Korrelator/Regler-Schaltung 6 ; 7b. Der zweite Eingang 9 dieser Eingänge ist über einen monostabilen Multivibrator 15 mit dem Steuereingang der Abtast/Halte-Schaltung 14c verbunden. Das Multiplikationsglied 14a besteht z. B. aus einem einfachen Polaritätsumschalter. Das Eingangssignal am ersten Eingang 8 der Korrelator/Regler-Schaltung 6 ; 7b wird im Rhythmus der rechteckförmigen Ausgangsspannung $V_G$ des Stromgenerators 3 ; 4 in der Polarität umgeschaltet und somit mit der Ausgangsspannung $V_G$ multipliziert. Die Abtast/Halte-Schaltung 14c tastet die Ausgangsspannung des Integrators 14b einmal pro Periode der Ausgangsspannung $V_G$ ab. Dadurch werden alle nach der Integration verbleibenden, synchron zur Ausgangsspannung $V_G$ des Stromgenerators 3 ; 4 pulsierenden Produkte der Multiplikation unterdrückt. Um eine gute Unterdrückung zu gewährleisten, soll die Abtastzeit der Abtast/Halte-Schaltung 14c, d. h. die Impulszeit des monostabilen Multivibrators 15, möglichst kurz sein. Der monostabile Multivibrator 15 wird z. B. jeweils durch eine positivgehende Flanke der Spannung $V_G$ gestartet.

Der Integrator 14b besitzt eine dreifache Funktion : Einerseits dient er der in einem Korrelator üblichen Mittelwertbildung des Istwertes am Ausgang von dessen Multiplikationsglied, dann vergleicht er diesen Mittelwert mit einer Referenzspannung Null, die als Sollwert wirkt, und zuletzt übt er die Funktion eines Integralreglers aus. Die Einstellung des Wertes des Uebertragungskoeffizienten des Magnetfeldsensors 1 bzw. der Magnetfeldsensoren 1a und 1b muss mit Hilfe einer Integralregelung erfolgen, damit der statische Fehler der Regelung wirklich einen Wert Null annimmt.

Die Dynamik der in der Fig. 6 dargestellten Schaltung kann durch die in der Fig. 7 dargestellten Schaltung verbessert werden, die ähnlich aufgebaut ist wie diejenige, die in der Fig. 6 dargestellt ist, nur dass dem ersten Eingang 8 der Korrelator/Regler-Schaltung 6 ; 7b noch eine Kaskadenschaltung eines Filters 16 und eines nachfolgenden Verstärkers 17 vorgeschaltet ist. Das Filter 16 ist z. B. im Fall einer rechteckförmigen Ausgangsspannung $V_G$ ein synchrones Zweipfadfilter, das von der Ausgangsspannung $V_G$ des Stromgenerators 3 ; 4 gesteuert wird. Das Filter 16 unterdrückt die Spannung $U_m$, die durch das zu messende Magnetfeld $H_m$ erzeugt wird und die in der Regel am Ausgang des Magnetfeldsensors 1 (siehe Fig. 1) bzw. am Ausgang des zweiten Differenzgebers 10 (siehe Fig. 2) und somit auch am Eingang 8 ansteht. Das Filter 16 soll jedoch die Spannung $V_h$ bzw. die Spannungen $V_h$ und $-V_h$ nicht dämpfen. Da nach dem Filter 16 die Amplituden der beiden Anteile insgesamt kleiner sind, müssen sie im nachfolgenden Verstärker 17 zusätzlich verstärkt werden. Diese zusätzliche Verstärkung entspricht dem Gewinn an Dynamik des Korrelators.

Der in der Fig. 8 dargestellte Integrator 14b ist eine an sich bekannte, mit Hilfe eines Operationsverstärkers 18 aufgebaute Schaltung, in der der Ausgang des Operationsverstärkers 18 über einen Kondensator C mit dessen invertierendem Eingang verbunden ist, der seinerseits über einen ersten Widerstand R1 auf einen ersten Eingang des Integrators geführt ist. Der nichtinvertierende Eingang des Operationsverstärkers 18 ist über einen zweiten gleich grossen Widerstand R2 oder direkt an die Masse gelegt.

Für die Signalform der Ausgangsspannung $V_G$ des Stromgenerators 3 ; 4 bzw. für die Signalform der Hilfsmagnetfelder $H_h$ und $-H_h$ sind zwei Randbedingungen zu erfüllen :
— Sie darf keine gemeisamen Frequenzanteile mit dem zu messenden Magnetfeld $H_m$ besitzen und
— ihr Frequenzbereich muss demjenigen des zu messenden Magnetfeldes $H_m$ sowei ähneln, dass der Uebertragungsfaktor der Magnetfeldsensoren 1, 1a und 1b für die Magnetfelder $H_m$, $H_h$ und $-H_h$ gleich gross ist.

Die einfachste Signalform für die vom Stromgenerator 3 ; 4 gelieferte Ausgangssignale $i_h$ und $V_G$ ist ein im Frequenzband begrenztes Rechtecksignal. In diesem Fall ist der Spannungsgenerator 3 und, wie bereits erwähnt, der Korrelator 6 besonders einfach und genau zu realisieren. Die gemeinsamen Frequenzanteile werden am einfachsten verhindert, indem die Frequenz der möglichst perfekt symmetrischen Rechtecksignale $i_h$ und $V_G$ so gewählt wird, dass die Frequenz der Grundwelle des zu messenden Stromes $i_m$ bzw. des zu messenden Magnetfeldes $H_m$ gleich einem geradzahligen Vielfachen dieser Frequenz der Rechtecksignale $i_h$ bzw. $V_G$ ist. In einem Elektrizitätszähler z. B. kann die Spannung $V_G$ erzeugt werden, indem die Grundwelle der Netzspannung mit einem Komparator bzw. einem Schmitt-Trigger ermittelt und die Frequenz der so erhaltenen Rechteckspannung durch eine gerade Zahl dividiert wird.

Wird eine der beschriebenen Schaltungsanordnungen in einem elektronischen Elektrizitätszähler verwendet, so könnte in betrügerischer Absicht versucht werden, das Messresultat des Elektrizitätszählers dadurch zu verfälschen, dass durch eine entsprechende Steuerung der Netzlast die geradzahligen Oberwellen der Netzfrequenz verstärkt und somit Anteile des zu messenden Stromes $i_m$ erzeugt werden, die eine gleiche oder ähnliche Signalform besitzen wie die Spannung $V_G$. Dies kann durch eine der folgenden Gegenmassnahmen verhindert werden :
— Als Ausgangssignale $V_G$ und $i_h$ des Stromgenerators 3 ; 4 wird eine mit der Netzspannung synchrome oder asynchrone Pseudo-Zufallsfolge von Impulsen verwendet.
— Die Ausgangssignale $V_G$ und $i_h$ des Stromgenerators 3 ; 4 werden, zufällig oder periodisch, zeitweise abgeschaltet, wobei vor jeder Abschaltung der vor der Abschaltung zuletzt geltente Wert der Ausgangsspannung $V_S$ des Reglers 7b mit Hilfe einer nicht dargestellten weiteren Abtast/Halte-Schaltung gespeichert und während den Abschaltzeiten der Pegel des dem Ausgangssignal $i_h$ bzw. $V_G$ ähnlichen Anteils der Ausgangsspannung $V_o$ der Schaltungsanordnung gemessen wird. Dieser Pegel kann jetzt entweder nur überwacht und beim Ueberschreiten einer vorgegebenen zulässigen Grenze ein Alarmsignal auslösen, oder aber als Offset-Spannung bei der Regelung automatisch berücksichtig, d. h. subtrahiert werden.

**Patentansprüche**

1. Schaltungsanordnung zur Kompensation von Schwankungen des Übertragungsfaktors eines Magnetfeldsensors (1, 1a), mit einer an einem Stromgenerator (3 ; 4) angeschlossenen Spule (5, 5a ; 5b) zur Erzeugung eines dem zu messenden Magnetfeld ($H_m$, $H_{m1}$) überlagerten Hilfsmagnetfeldes ($H_h$), mit einem Differenzgeber (10, 7a) und mit einem Mittel (6) zur Bestimmung des allein durch das Hilfsmagnetfeld ($H_h$) erzeugten Anteils der Ausgangsspannung ($V_H$, $V_{Ha}$) des Magnetfeldsensors (1, 1a), wobei ein erster Eingang (8) des Mittels (6) am Ausgang des Magnetfeldsensors (1, 1a) und ein zweiter Eingang (9) des Mittels (6) an einem Spannungsausgang des Stromgenerators (3 ; 4) angeschlossen ist und wobei der Ausgang des Mittels (6) über einen Regler (7b) mit einem Steuereingang des Magnetfeldsensors (1, 1a) verbunden ist, der den Wert des Übertragungskoeffizienten des Magnetfeldsensors (1, 1a) beeinfluust, dadurch gekennzeichnet, dass zwischen dem Magnetfeldsensor (1, 1a) und dem ersten Eingang (8) des Mittels (6) der Differenzgeber (10) geschaltet ist, dessen erster Eingang mit dem Ausgang des Magnetfeldsensors (1, 1a), dessen zweiter Eingang über ein Dämpfungsglied (11) mit dem Spannungsausgang des Stromgenerators (3 ; 4) und dessen Ausgang mit dem ersten Eingang (8) des Mittels (6) verbunden ist.

2. Schaltungsanordnung nach Anspruch 1, dadurch gekennzeichnet, dass zusätzlich zum ersten Magnetfeldsensor (1a), dem die Spule (5) zugeordnet ist, noch ein zweiter Magnetfeldsensor (1b) vorhanden ist, der ausschliesslich zur Ermittlung des zu messenden Magnetfeldes dient, dass der Ausgang des Differenzgebers (10) mit dem einen Eingang und der Ausgang des zweiten Magnetfeldsensors (1b) mit dem andern Eingang eines weiteren Differenzgebers (13) verbunden ist, dessen Ausgang seinerseits am ersten Eingang (8) des Mittels (6) angeschlossen ist, und dass die Steuereingänge der beiden Magnetfeldsensoren (1a, 1b) miteinander verbunden sind.

3. Schaltungsanordnung nach Anspruch 1, dadurch gekennzeichnet, dass zusätzlich zum ersten Magnetfeldsensor (1a) noch ein zweiter annähernd gleicher Magnetfeldsensor (1b) vorhanden ist, dass die Spule (5) aus zwei annähernd gleichen Teilspulen (5a, 5b) besteht, die je einem der beiden Magnetfeldsensoren (1a, 1b) zugeordnet sind, dass die Ausgänge der beiden Magnetfeldsensoren (1a, 1b) über eine gemeinsame Additionsschaltung (12a) mit dem Ausgang der Schaltungsanordnung verbunden sind, dass die beiden Teilspulen (5a, 5b) vom gemeinsamen Stromgeneratpr (3 ; 4) gespeit sind, dass die beiden von den Teilspulen (5a, 5b) erzeugten Hilfsmagnetfelder ($H_h$, — $H_h$) einen gleichen Absolutwert, aber entgegengesetzte Richtungen besitzen, dass der erste Eingang das Differenzgebers (10) mit dem Ausgang eines weiteren Differenzgebers (12b) verbunden ist, dessen beiden Eingänge auf je einen Ausgang der beiden Magnetfeldsensoren (1a, 1b) geführt sind, und dass die Steuereingänge der beiden Magnetfeldsensoren (1a, 1b) miteinander verbunden sind.

4. Schaltungsanordnung nach dem Oberbegriff des Anspruchs 1, wobei der Differenzgeber (7a) zwischen dem Mittel (6) und dem Regler (7b) geschaltet ist, so dass sein erster Eingang mit dem Ausgang des Mittels (6) verbunden ist und sein zweiter Eingang an einer konstanten Referenzspannung ($V_{Ref}$) liegt, dadurch gekennzeichnet, dass zusätzlich zum ersten Magnetfeldsensor (1a) noch ein zweiter annähernd gleicher Magnetfeldsensor (1b) vorhanden ist, dass die Spule (5) aus zwei annähernd gleichen Teilspulen (5a, 5b) besteht, die je einem der beiden Magnetfeldsensoren (1a, 1b) zugeordnet sind, dass die Ausgänge der beiden Magnetfeldsensoren (1a, 1b) über eine gemeinsame Additionsschaltung (12a) mit dem Ausgang der Schaltungsanordnung verbunden sind, dass die beiden Teilspulen (5a, 5b) vom gemeinsamen Stromgenerator (3 ; 4) gespeist sind, dass die beiden von den Teilspulen (5a, 5b) erzeugten Hilfsmagnetfelder ($H_h$, — $H_h$) einen gleichen Absolutwert, aber entgegengesetzte Richtungen besitzen, dass der erste Eingang (8) des Mittels (6) mit dem Ausgang eines weiteren Differenzgebers (12b) verbunden ist, dessen beiden Eingänge auf je einen Ausgang der beiden Magnetfeldsensoren (1a, 1b) geführt sind, und dass die Steuereingänge der beiden Magnetfeldsensoren (1a, 1b) miteinander verbunden sind.

5. Schaltungsanordnung nach Anspruch 3 oder 4, dadurch gekennzeichnet, dass die beiden Teilspulen (5a, 5b) je ein Teil einer gemeinsamen Spule (5) sind und dass sie jeweils nur aus parallelen und vom Strom ($i_h$) des Stromgenerators (3 ; 4) in gleicher Richtung durchflossenen Leitern bestehen, wobei die Stromrichtungen in den beiden Teilspulen (5a, 5b) parallele und entgegengesetzte Richtungen besitzen.

6. Schaltungsanordnung nach einem der Ansprüche 1 bis 5, dadurch gekennzeichnet, dass die Spule (5) bzw. die beiden Teilspulen (5a, 5b) Flachspulen sind, die an der Oberfläche auf einem Halbleiterkristall angeordnet sind, in dem mindestens der bzw. die Magnetfeldsensoren (1 bzw. 1a, 1b) integriert sind.

7. Schaltungsanordnung nach Anspruch 6, dadurch gekennzeichnet, dass die Flachspule spiralförmig ist und annähernd rechteckförmige Windungen besitzt.

8. Schaltungsanordnung nach einem der Ansprüche 1 bis 7, dadurch gekennzeichnet, dass das Mittel (6) zur Bestimmung des allein durch das Hilfsmagnetfeld ($H_h$) bzw. durch die Hilfsmagnetfelder ($H_h$, — $H_h$) erzeugten Anteils der Ausgangsspannung ($V_H$) des Magnetfeldsensors (1) bzw. der Ausgangsspannungen ($V_{Ha}$, $V_{Hb}$) der Magnetfeldsensoren (1a, 1b) ein Korrelator ist.

9. Schaltungsanordnung nach Anspruch 8, dadurch gekennzeichnet, dass der Regler (7b) ein Integralregler ist.

10. Schaltungsanordnung nach Anspruch 9, dadurch gekennzeichnet, dass die aus dem Korrelator (6) und dem Regler (7b) bestehende Korrelator/Regler-Schaltung (6 ; 7b) ein Multiplikationsglied (14a) enthält, das mit einem nachgeschalteten Integrator (14b) in Kaskade geschaltet ist, dass der Integrator (14b) über eine Abtast/Halte-Schaltung (14c) mit dem Steuereingang der Magnetfeldsensoren (1 bzw. 1a, 1b) verbunden ist und dass der Steuereingang der Abtast/Halte-Schaltung (14c) über einen monostabilen Multivibrator (15) von demjenigen Eingang (9) der Korrelator/Regler-Schaltung (6 ; 7b) angesteuert ist, der direkt an einem Ausgang des Stromgenerators (3 ; 4) angeschlossen ist.

11. Schaltungsanordnung nach Anspruch 10, dadurch gekennzeichnet, dass das Multiplikationsglied (14a) ein Polaritätsumschalter ist.

12. Schaltungsanordnung nach einem der Ansprüche 8 bis 11, dadurch gekennzeichnet, dass demjenigen Eingang der Korrelator/Regler-Schaltung (6 ; 7b), der von dem bzw. den Magnetfeldsensoren (1 bzw. 1a, 1b) angesteuert ist, eine Kaskadenschaltung eines Filters (16) und eines nachfolgenden Verstärkers (17) vorgeschaltet ist.

13. Schaltungsanordnung nach einem der Ansprüche 1 bis 12, dadurch gekennzeichnet, dass die vom Stromgenerator (3 ; 4) gelieferten Ausgangssignale ($i_h$, $V_G$) Rechtecksignale sind.

14. Schaltungsanordnung nach Anspruch 13, dadurch gekennzeichnet, dass die Frequenz der Grundwelle eines zu messenden Stromes ($i_m$) bzw. des zu messenden Magnetfeldes ($H_m$) ein geradzahliges Vielfaches der Frequenz der Rechtecksignale ist.

15. Schaltungsanordnung nach Anspruch 13 oder 14, dadurch gekennzeichnet, dass die Ausgangssignale ($i_h$, $V_G$) des Stromgenerators (3 ; 4) eine Pseudo-Zufallsfolge von Impulsen sind.

## Claims

1. A circuit arrangement for compensating for fluctuations in the transfer factor of a magnetic field sensor (1, 1a) comprising a coil (5, 5a ; 5b) connected to a current generator (3 ; 4), for producing an auxiliary magnetic field ($H_h$) which is superimposed on the magnetic field ($H_m$, $H_{m1}$) to be measured, a differential means (10, 7a), and a means (6) for determining the component, which is produced solely by the auxiliary magnetic field ($H_h$), of the output voltage ($V_H$, $V_{Ha}$) of the magnetic field sensor (1, 1a), wherein a first input (8) of the means (6) is connected to the output of the magnetic field sensor (1, 1a) and a second input (9) of the means (6) is connected to a voltage output of the current generator (3 ; 4), and wherein the output of the means (6) is connected by way of a regulator (7b) to a control input of the magnetic field sensor (1, 1a) which influences the value of the transfer coefficient of the magnetic field sensor (1, 1a) characterised in that connected between the magnetic field sensor (1, 1a) and the first input (8) of the means (6) is the differential means (10) whose first input is connected to the output of the magnetic field sensor (1, 1a), whose second input is connected by way of an attenuation member (11) to the voltage output of the current generator (3 ; 4) and whose output is connected to the first input (8) of the means (6).

2. A circuit arrangement according to claim 1 characterised in that in addition to the first magnetic field sensor (1a) with which the coil (5) is associated there is also a second magnetic field sensor (1b) which serves exclusively for determining the magnetic field to be measured, that the output of the differential means (10) is connected to the one input of a further differential means (13) and the output of the second magnetic field sensor (1b) is connected to the other input of the further differential means (13), the output of the further differential means in turn being connected to the first input (8) of the means (6), and that the control inputs of the two magnetic field sensors (1a, 1b) are connected together.

3. A circuit arrangement according to claim 1 characterised in that in addition to the first magnetic field sensor (1a) there is also a second approximately identical magnetic field sensor (1b), that the coil (5) comprises two approximately identical coil portions (5a, 5b) which are each associated with a respective one of the two magnetic field sensors (1a, 1b), that the outputs of the two magnetic field sensors (1a, 1b) are connected to the output of the circuit arrangement by way of a common addition circuit (12a), that the two coil portions (5a, 5b) are fed by the common current generator (3 ; 4), that the two auxiliary magnetic fields ($H_h$, — $H_h$) produced by the coil portions (5a, 5b) are of the same absolute value but are of opposite directions, that the first input of the differential means (10) is connected to the output of a further differential means (12b), the two inputs of which are connected to an output of respective ones of the magnetic field sensors (1a, 1b), and that the control inputs of the two magnetic field sensors (1a, 1b) are connected together.

4. A circuit arrangement according to the classifying portion of claim 1 wherein the differential means (7a) is connected between the means (6) and the regulator (7b) so that its first input is connected to the output of the means (6) and its second input is at a constant reference voltage ($V_{ref}$), characterised in that in addition to the first magnetic field sensor (1a) there is also a second approximately identical magnetic field sensor (1b), that the coil (5) comprises two approximately identical coil portions (5a, 5b) which are each associated with a respective one of the two magnetic field sensors (1a, 1b), that the outputs of the two magnetic field sensors (1a, 1b) are connected to the output of the circuit arrangement by way of a common addition circuit (12a), that the two coil portions (5a, 5b) are fed by the common current generator (3 ; 4), that the two auxiliary magnetic fields ($H_h$, — $H_h$) produced by the coil portions (5a, 5b) are of the same absolute value but are of opposite directions, that the first input (8) of the means (6) is connected to the output of a further differential means (12b) whose two inputs are connected to an output of respective ones of the two magnetic field sensors (1a, 1b) and that the control inputs of the two magnetic field sensors (1a, 1b) are connected together.

5. A circuit arrangement according to claim 3 or claim 4 characterised in that the two coil portions (5a, 5b) are each a respective portion of a common coil (5) and that they each only comprise parallel conductors through which the current ($i_h$) of the current generator (3 ; 4) flows in the same direction,

# EP 0 172 402 B1

wherein the current directions in the two coil portions (5a, 5b) are in parallel and opposite directions.

6. A circuit arrangement according to one of claims 1 to 5 characterised in that the coil (5) or the two coil portions (5a, 5b) are flat coils which are disposed at the surface on a semiconductor crystal in which at least the magnetic field sensor or sensors (1 and 1a, 1b respectively) are integrated.

7. A circuit arrangement according to claim 6 characterised in that the flat coil is of a spiral configuration and has approximately rectangular windings.

8. A circuit arrangement according to one of claims 1 to 7 characterised in that the means for determining the portion, which is produced solely by the auxiliary magnetic field ($H_h$) or the auxiliary magnetic fields ($H_h$, — $H_h$), of the output voltage ($V_H$) of the magnetic field sensor (1) or the output voltages ($V_{Ha}$, $V_{Hb}$) of the magnetic field sensors (1a, 1b) is a correlator.

9. A circuit arrangement according to claim 8 characterised in that the regulator (7b) is an integral regulator.

10. A circuit arrangement according to claim 9 characterised in that the correlator/regulator circuit (6 ; 7b) consisting of the correlator (6) and the regulator (7b) includes a multiplication member (14a) which is connected in cascade relationship with an integrator (14b) connected on the output side thereof, that the integrator (14b) is connected by way of a sample-hold circuit (14c) to the control input of the magnetic field sensors (1 and 1a, 1b) and that the control input of the sample-hold circuit (14c) is actuated by way of a monostable multivibrator (15) by that input (9) of the correlator/regulator circuit (6 ; 7b) which is connected directly to an output of the current generator (3 ; 4).

11. A circuit arrangement according to claim 10 characterised in that the multiplication member (14a) is a polarity reversing switch.

12. A circuit arrangement according to one of claims 8 to 11 characterised in that connected on the input side of that input of the correlator/regulator circuit (6 ; 7b) which is actuated by the magnetic field sensor or sensors (1 and 1a, 1b) is a cascade circuit of a filter (16) and an amplifier (17) on the output side thereof.

13. A circuit arrangement according to one of claims 1 to 12 characterised in that the output signals ($i_h$, $V_G$) supplied by the current generator (3 ; 4) are rectangular signals.

14. A circuit arrangement according to claim 13 characterised in that the frequency of the fundamental wave of a current ($i_m$) to be measured or the magnetic field ($H_m$) to be measured is an even multiple of the frequency of the rectangular signals.

15. A circuit arrangement according to claim 13 or claim 4 characterised in that the output signals ($i_h$, $V_G$) of the current generator (3 ; 4) are a pseudo-random sequence of pulses.


**Revendications**

1. Disposition de circuit pour la compensation de fluctuations du facteur de transfert d'un capteur (1, 1a) de champ magnétique, avec une bobine (5, 5a ; 5b) reliée à un générateur (3 ; 4) de courant pour engendrer un champ magnétique auxiliaire ($H_h$) superposé au champ magnétique à mesurer ($H_m$, $H_{m1}$), avec un différenciateur (10, 7a) et avec un moyen (6) pour déterminer la partie de la tension de sortie ($V_H$, $V_{Ha}$) du capteur (1, 1a) de champ magnétique engendrée par le seul champ magnétique auxiliaire ($H_h$), la première entrée (8) du moyen (6) étant reliée à la sortie du détecteur (1, 1a) de champ magnétique et une deuxième entrée (9) du moyen (6) étant reliée à une sortie de tension du générateur (3 ; 4) de courant et la sortie du moyen (6) étant reliée par un régulateur (7b) avec une entrée de commande du capteur (1, 1a) de champ magnétique, qui influe sur la valeur du coefficient de transfert du capteur (1, 1a) de champ magnétique, caractérisée en ce que, entre le capteur (1, 1a) de champ magnétique et la première entrée (8) du moyen (6) est monté le différenciateur (10), dont la première sortie est reliée avec la sortie du capteur (1, 1a) de champ magnétique, dont la deuxième entrée est reliée à travers un atténuateur (11) avec la tension de sortie du générateur (3 ; 4) de courant et dont la sortie est reliée avec la première entrée (8) du moyen (6).

2. Disposition de circuit selon la revendication 1, caractérisée en ce que, en plus du premier capteur (1a) de champ magnétique, auquel est affectée la bobine (5), il est prévu aussi un deuxième capteur (1b) de champ magnétique, qui sert exclusivement à déterminer le champ magnétique à mesurer, en ce que la sortie du différenciateur (10) est reliée avec l'entrée du deuxième capteur (1b) de champ magnétique et la sortie de ce deuxième capteur est reliée avec l'autre entrée d'un autre différenciateur (13), dont la sortie de son côté est reliée à la première entrée (8) du moyen (6), et en ce que les entrées de commande des deux capteurs (1a, 1b) de champ magnétique sont reliées l'une à l'autre.

3. Disposition de circuit selon la revendication 1, caractérisée en ce que, en plus du premier capteur (1a) de champ magnétique, il est prévu un autre capteur (1b) de champ magnétique approximativement identique, en ce que la bobine (5) se compose de deux parties (5a, 5b) de bobine approximativement identiques, qui sont affectées chacune à l'un des deux capteurs (1a, 1b) de champ magnétique, en ce que les sorties des deux capteurs (1a, 1b) de champ magnétique sont reliées à travers un circuit additionneur (12a) commun avec la sortie de la disposition de circuit, en ce que les deux bobines partielles (5a, 5b) sont alimentées par le générateur (3 ; 4) commun de courant, en ce que les deux champs magnétiques ($H_h$, — $H_h$) engendrés par les deux bobines partielles (5a, 5b) possèdent une valeur absolue égale, mais des

9

directions opposées, en ce que la première entrée du différenciateur (10) est reliée avec la sortie d'un autre différenciateur (12b), dont les deux entrées sont amenées chacune à une sortie des deux capteurs (1a, 1b) de champs magnétiques, et en ce que les entrées de commande des deux capteurs (1a, 1b) de champs magnétiques sont reliées l'une à l'autre.

4. Disposition de circuit selon le préambule de la revendication 1, le différenciateur (7a) étant relié entre le moyen (6) et le régulateur (7b), de sorte que sa première entrée est reliée avec la sortie du moyen (6) et sa deuxième entrée est maintenue à une tension de référence constante ($V_{Ref}$), caractérisée en ce que, en plus du premier capteur (1a) de champ magnétique, il est prévu également un deuxième capteur (1b) de champ magnétique approximativement identique, que la bobine (5) se compose de deux bobines (5a, 5b) approximativement identiques qui sont affectées chacune à l'une des deux capteurs (1a, 1b) de champs magnétiques, que les sorties des deux capteurs (1a, 1b) de champs magnétiques sont reliées par un circuit additionneur (12a) commun avec la sortie de la disposition de circuit, en ce que les deux bobines partielles (5a, 5b) sont alimentées par le générateur (3 ; 4) commun de courant, en ce que les deux champs magnétiques ($H_h$, — $H_h$) engendrés par les deux bobines partielles (5a, 5b) possèdent une valeur absolue égale, mais des directions opposées, en ce que la première entrée (8) du moyen (6) est reliée avec la sortie d'un autre différenciateur (12b), dont les deux entrées sont amenées chacune à une sortie des deux capteurs (1a, 1b) de champs magnétiques, et en ce que les entrées de commande des deux capteurs (1a, 1b) de champs magnétiques sont reliées l'une à l'autre.

5. Disposition de circuit selon la revendication 3 ou 4, caractérisée en ce que les deux bobines partielles (5a, 5b) sont chacune une partie d'une bobine (5) commune et en ce qu'elles se composent respectivement simplement de conducteurs parallèles et parcourus par le courant ($i_h$) du générateur (3 ; 4) de courant dans la même direction, les directions de courant dans les deux parties (5a, 5b) présentant des directions parallèles et opposées.

6. Disposition de circuit selon l'une des revendications 1 à 5, caractérisée en ce que la bobine (5) ou les deux parties de bobine (5a, 5b) sont des bobines plates qui sont disposées sur la surface d'un cristal semiconducteur dans lequel sont intégrés au moins le ou les capteurs (1 ou 1a, 1b) de champs magnétiques.

7. Disposition de circuit selon la revendication 6, caractérisée en ce que la bobine plate présente une forme de spirale et possède des enroulements approximativement rectangulaires.

8. Disposition de circuit selon l'une des revendications 1 à 7, caractérisée en ce que le moyen (6) de détermination de la partie de tension de sortie $V_H$ du capteur (1) de champ magnétique ou des tensions de sortie ($V_{Ha}$, $V_{Hb}$) des capteurs (1a, 1b) de champs magnétiques engendrées par le seul champ magnétique auxiliaire ($H_h$) ou les champs magnétiques auxiliaires ($H_h$, — $H_h$) est un corrélateur.

9. Disposition de circuit selon la revendication 8, caractérisée en ce que le régulateur (7b) est un régulateur intégral.

10. Disposition de circuit selon la revendication 9, caractérisée en ce que le circuit corrélateur/régulateur (6 ; 7b) qui est composé du corrélateur (6) et du régulateur (7b) comprend un multiplicateur (14a), qui est relié en cascade avec un intégrateur (14b) monté en aval, en ce que l'intégrateur (14b) est relié par un circuit échantillonneur/bloqueur (14c) avec une entrée de commande du ou des capteurs (1 ou 1a ; 1b) de champs magnétiques, et en ce que l'entrée de commande du circuit échantillonneur/bloqueur est commandée à travers un multivibrateur monostable (15) par l'entrée (9) du circuit (6 ; 7b) corrélateur/régulateur qui est reliée directement à une sortie du générateur (3 ; 4) de courant.

11. Disposition de circuit selon la revendication 10, caractérisée en ce que le multiplicateur (14a) est un inverseur de polarité.

12. Disposition de circuit selon l'une des revendications 8 à 11, caractérisée en ce qu'on relie un circuit en cascade composé d'un filtre (16) et d'un amplificateur (17) qui le suit en amont de l'entrée du circuit (6 ; 7b) corrélateur/régulateur qui est commandée par le ou les capteurs (1 ou 1a ; 1b) de champs magnétiques.

13. Disposition de circuit selon l'une des revendications 1 à 12, caractérisée en ce que les signaux de sortie ($i_h$, $V_G$) émis par le générateur (3 ; 4) de courant sont des signaux rectangulaires.

14. Disposition de circuit selon la revendication 13, caractérisée en ce que la fréquence de l'onde fondamentale d'un courant ($i_m$) à mesurer ou d'un champ magnétique ($H_m$) à mesurer est un multiple entier de la fréquence de signaux rectangulaires.

15. Disposition de circuit selon la revendication 13 ou 14, caractérisée en ce que les signaux de sortie ($i_h$, $V_G$) du générateur (3 ; 4) de courant sont une séquence pseudoaléatoire d'impulsions.

Fig. 1

Fig. 2

Fig. 3

# Fig. 4

# Fig. 5

# Fig. 6

# Fig. 7

# Fig. 8

3